Europäisches Patentamt

European Patent Office

Office européen des brevets

(11) Veröffentlichungsnummer: **0 223 012**
**A2**

## (12) EUROPÄISCHE PATENTANMELDUNG

(21) Anmeldenummer: **86112912.0**

(51) Int. Cl.⁴: **H05K 13/04**

(22) Anmeldetag: **18.09.86**

(30) Priorität: **16.10.85 DE 3536870**

(43) Veröffentlichungstag der Anmeldung:
**27.05.87 Patentblatt 87/22**

(84) Benannte Vertragsstaaten:
**BE CH FR GB IT LI NL**

(71) Anmelder: **Preh Industrieausrüstungen GmbH**
**Schweinfurter Strasse 5 Postfach 1740**
**D-8740 Bad Neustadt/Saale(DE)**

(72) Erfinder: **Bardroff, Hans**
**Schuhmarktstrasse 12**
**D-8740 Bad Neustadt/Saale(DE)**
Erfinder: **Laukenmann, Erich, Dipl.-Ing.**
**Mönchsweg 30**
**D-8740 Bad Neustadt/Saale(DE)**

(54) **Montageeinrichtung.**

(57) Eine Montageeinrichtung zur lagerichtigen Zuführung eines Bauelements 18 zu einem in einer Arbeitsstation 27 gehaltenen Träger 28 weist an einem Transportkopf 1 eine Haltevorrichtung 7 auf, die das Bauelement 18 an seinem gegenüber seinen Anschlußstiften 19 möglicherweise versetzten Gehäuse 17 hält.

Um trotz des Versatzes die Anschlußstifte 19 lagerichtig dem Träger zuzuführen, ist in einem bestimmten Abstand A zur Arbeitsstation 27 eine Klemmvorrichtung 20 angeordnet. In dieser ist das Bauelement 18 an seinen Anschlußstiften 19 ausgerichtet gehalten. Die Haltevorrichtung 7 ist am Transportkopf 1 solange beweglich gelagert, bis sie das Gehäuse 17 des an den Anschlußstiften 19 in der Klemmvorrichtung 20 gehaltenen Bauelements 18 fest ergriffen hat.

Fig. 1

EP 0 223 012 A2

## Montageeinrichtung

Die Erfindung betrifft eine Montageeinrichtung zur lagerichtigen Zuführung eines Bauelements zu einem in einer Arbeitsstation gehaltenen Träger, wobei die Montageeinrichtung an einem Transportkopf eine Haltevorrichtung aufweist, die beim Transport das Bauelement an seinem Hauptteil hält und das Bauelement außer dem Hauptteil wenigstens ein in den Träger einzuführendes Einsteckteil aufweist.

Mit einer solchen Montageeinrichtung soll ein mechanisches oder elektrisches Bauelement zu einem Träger gebracht und mit seinem Einsteckteil in eine am Träger vorgesehene Aufnahme eingesetzt werden. Die Haltevorrichtung hält dabei das Hauptteil des Bauelements. Solange zwischen dem Hauptteil und dem Einsteckteil keine wesentlichen Toleranzen bestehen, treten keine besondern Schwierigkeiten auf.

Mit einer solchen Montageeinrichtung werden beispielsweise elektrische Bauelemente an einer gelochten Trägerplatte montiert. Solche Bauelemente weisen als Einsteckteil Anschlußstifte auf. Ihr Hauptteil ist von einem Gehäuse gebildet. Es hat sich gezeigt, daß zwischen dem Gehäuse und den Anschlußstiften beträchtliche Toleranzen auftreten. Besonders große Toleranzen ergeben sich beispielsweise, wenn die über die Anschlußstifte anzuschließende elektrische Schaltung in das Gehäuse eingegossen ist, da beim Eingießen bzw. Aushärten des Gießharzes das Gehäuse unkontrolliert schrumpfen kann. Dies hat zur Folge, daß dann, wenn das am Gehäuse gehaltene Bauelement über die Trägerplatte gefahren ist, die Anschlußstifte nicht mit den Löchern der Trägerplatte fluchten. Die Haltevorrichtung an den Anschlußstiften angreifen zu lassen, verbietet sich, da diese keine hinreichende Angriffsfläche bieten. Um die Anschlußstifte gegenüber den Löchern der Trägerplatte auszurichten, werden nach dem Stand der Technik die Anschlußstifte bei in der Haltevorrichtung gehaltenem Gehäuse so verbogen, daß sie mit den Löchern der Trägerplatte fluchten. Dieses Verbiegen der Anschlußstifte ist gefährlich. Denn dabei können diese brechen oder überdehnt werden. Es können jedoch auch die im Gehäuse liegenden elektrischen Anschlußstellen beschädigt werden. Selbst wenn keine sofort feststellbaren Beschädigungen entstehen, ist nicht ausgeschlossen, daß durch das Verbiegen der Anschlüsse Schäden entstehen, die sich erst im Laufe der Zeit auswirken, was die Zuverlässigkeit der Schaltung beeinträchtigt.

Um ein maschinelles Verbiegen der Anschlußstifte zu vermeiden, werden häufig Bauelemente, bei denen mit größeren Toleranzen zwischen dem Gehäuse und den Anschlußstiften zu rechnen ist, von Hand in die Trägerplatte eingesetzt. Hierbei ist ein Verbiegen der Anschlußstifte kaum erforderlich. Denn die Anschlußstifte müssen nicht nach der jeweiligen Gehäuseform bzw. der Toleranz zwischen den Anschlußstiften und dem Gehäuse ausgerichtet werden. Denn diese ist für die elektrische Funktion unwesentlich.

Aufgabe der Erfindung ist es, eine Montageeinrichtung der eingangs genannten Art vorzuschlagen, bei der das Bauelement trotz Toleranzen zwischen seinem Hauptteil und seinem Einsteckteil bezüglich des Einsteckteils lagerichtig zum Träger an der Haltevorrichtung haltbar ist, wodurch insbesondere ein Verbiegen des Einsteckteils vermieden sein soll.

Erfindungsgemäß ist obige Aufgabe bei einer Montageeinrichtung der eingangs genannten Art dadurch gelöst, daß in einem bestimmten Abstand zur Arbeitsstation eine Klemmvorrichtung angeordnet ist, in der das Bauteil an seinem Einsteckteil ausgerichtet zu halten ist, daß die Haltevorrichtung am Transportkopf beweglich gelagert ist und daß eine Feststellvorrichtung zwischen dem Transportkopf und der Haltevorrichtung vorgesehen ist, die die Haltevorrichtung gegenüber dem Transportkopf arretiert, wenn die Haltevorrichtung das Hauptteil des mit seinem Einsteckteil an der Klemmvorrichtung eingespannten Bauelements fest ergriffen hat. Die nach der Montage nicht mehr störenden Toleranzen zwischen dem Hauptteil und dem Einsteckteil des Bauelements werden hierbei durch die Beweglichkeit der Haltevorrichtung kompensiert. Die Haltevorrichtung stellt sich also von selbst entsprechend der jeweiligen Toleranzen beim Ergreifen des Hauptteils ein. Das Hauptteil wird nicht gegen das in die Klemmvorrichtung eingespannte Einsteckteil verbogen. Nach dieser Einstellung arretiert die Feststellvorrichtung die Haltevorrichtung gegenüber dem Transportkopf. Danach wird der Transportkopf um den vorbestimmten Abstand zum Träger verfahren und das Bauelement wird mit seinem Einsteckteil in die vorgesehene Aufnahme des Trägers eingesetzt. Ein Nachrichten, insbesondere Verbiegen des Einsteckteils erübrigt sich.

In bevorzugter Ausgestaltung der Erfindung ist die Haltevorrichtung in der X-Y-Richtung verschieblich und um die Z-Achse drehbar am Transportkopf gelagert. Dadurch lassen sich in der X-Y-Ebene auftretende Abweichungen der Lage oder Gestalt des Hauptteils gegenüber seinem Nennmaß ausgleichen. Sollen auch Schrägstellungen zwischen dem Einsteckteil und dem Hauptteil ausgeglichen werden, ist die Haltevorrichtung am Transportkopf pendelnd gelagert.

Um zu verhindern, daß sich die Haltevorrichtung infolge ihrer beweglichen Lagerung am Transportkopf wesentlich mehr verstellt, als dies zum Ausgleich der möglichen Toleranzen nötig ist, sind in bevorzugter Ausgestaltung der Erfindung Anschläge zur Begrenzung der freien Beweglichkeit zwischen der Haltevorrichtung und dem Transportkopf vorgesehen. Es ist dadurch vermieden, daß sich die Haltevorrichtung so weit verdreht oder verschiebt, daß sie das in die Klemmvorrichtung eingespannte Bauelement nicht mehr ohne weiteres ergreifen kann.

Weitere vorteilhafte Ausgestaltungen der Erfindung ergeben sich aus den weiteren Unteransprüchen und der folgenden Beschreibung. In der Zeichnung zeigen:

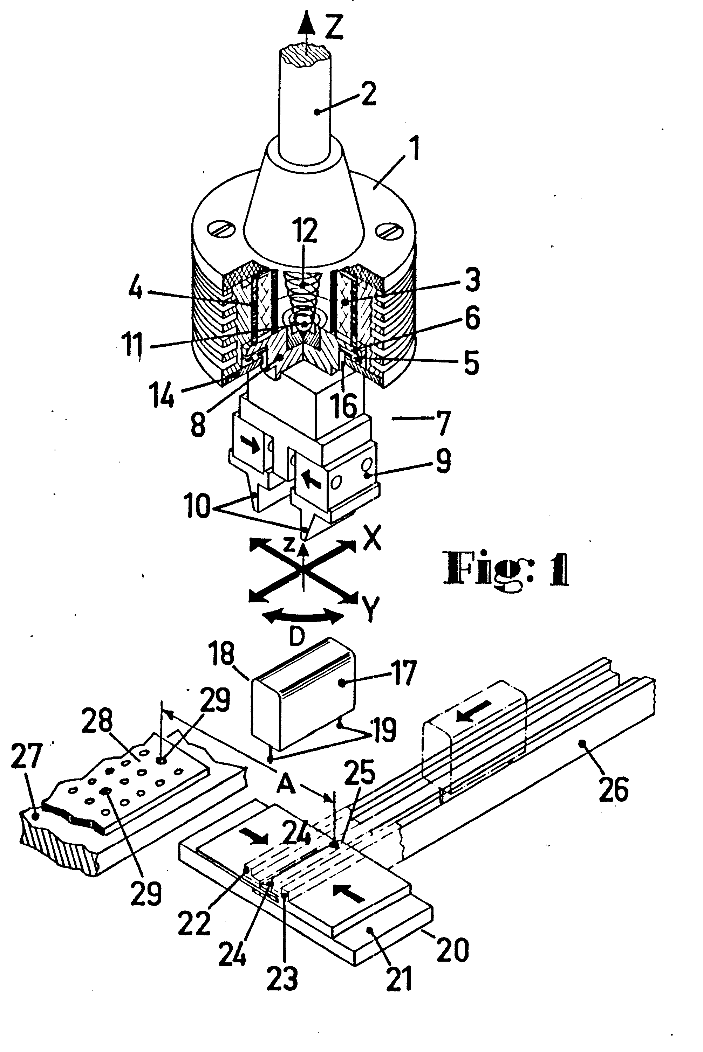

Figur 1 eine Montageeinrichtung, teilweise - schematisch,

Figur 2 eine Anschlagsgestaltung zwischen einem Transportkopf und einer Haltevorrichtung,

Figur 3 ein zweites Ausführungsbeispiel einer Haltevorrichtung,

Figur 4 ein drittes Ausführungsbeispiel einer Haltevorrichtung in Aufsicht und

Figur 5 die Haltevorrichtung nach Figur 4 in Seitenansicht.

Die Montageeinrichtung weist einen Transportkopf 1 auf, der am Arm 2 eines Roboters befestigt ist. Im Innern der Transportkopfes 1 ist ein Weicheisenkern 3 angeordnet, der von einer Spule 4 umschlossen ist. In dem Transportkopf 1 ist ein Kugelring 5 gelagert, auf dem ein Bund 6 einer unten am Transportkopf 1 vorgesehenen Haltevorrichtung 7 aufliegt. Der Bund 6 ist an einem Lagerstück 8 ausgebildet, an dem eine Spannzange 9 befestigt ist. Backen 10 der Spannzange 9 sind beispielsweise pneumatisch gesteuert zu öffnen und zu schließen.

In einer Vertiefung des Lagerstücks 8 liegt eine Kugel 11, auf der eine Druckfeder 12 aufsitzt, welche sich im Transportkopf 1 abstützt.

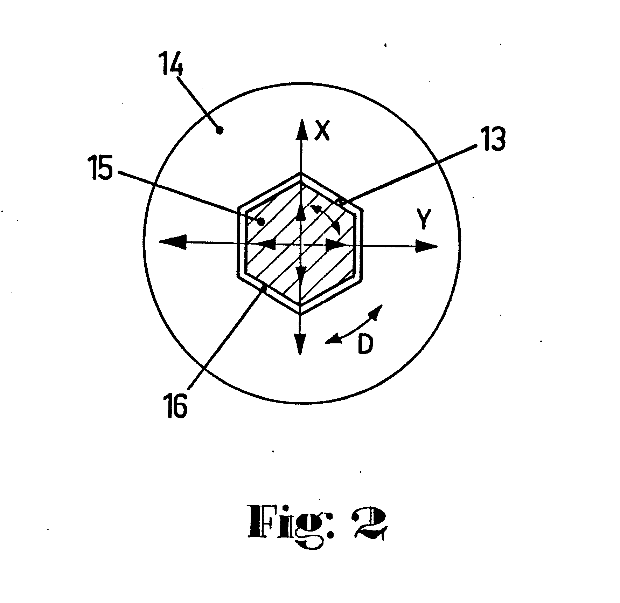

Das Lagerstück 8 durchragt eine sechseckige Öffnung 13 einer Bodenplatte 14 das Transportkopfes 1. Das Lagerstück 8 selbst weist in diesem Bereich ebenfalls sechseckigen Querschnitt 15 auf (vgl. Figur 2). Der Querschnitt der Öffnung 13 ist größer als der Querschnitt 15, so daß ein umlaufender Spalt 16 besteht.

Die Funktionsweise der beschriebenen Lagerung der Haltevorrichtung 7 am Transportkopf 1 ist etwa folgende:

Ist der von der Spule 4 und dem Weicheisenkern 3 gebildete Elektromagnet nicht erregt, dann wird das Lagerstück 8 durch die Druckfeder 12 über die Kugel 11 in Mittenstellung gehalten. Das Lagerstück 8 läßt sich auf dem Kugelring 5 in der X-Y-Ebene in allen Richtungen so weit verschieben, bis der Querschnitt 15 am Rand der Öffnung 13 anschlägt. Außerdem läßt sich das Lagerstück 8 auch um die Z-Achse verdrehen (vgl. Pfeil D) und zwar ebenfalls bis der Querschnitt 15 an der Öffnung 13 anschlägt. Die freie Beweglichkeit ist also sowohl für lineare Verschiebungen als auch für Drehungen begrenzt. Diese Begrenzung ist so ausgelegt, daß sie nicht kleiner ist als die möglichen Abweichungen eines von der Spannzange 9 zu ergreifenden Hauptteils 17 eines Bauelements 18 gegenüber dessen Einsteckteil 19.

Wird der Elektromagnet erregt, dann wird das Lagerstück 8 und damit die Haltevorrichtung 7 an ihrem Bund 6 festgehalten. Ganz unabhängig davon, in welcher Stellung das Lagerstück 8 gegenüber dem Transportkopf 1 steht. Wird der Elektromagnet wieder entregt, wird das Lagerstück 8 unter der Kraft der Druckfeder 12 wieder frei beweglich.

Im Beispielsfalle ist das Bauelement 18 ein elektrisches Bauelement, bei dem das Einsteckteil 19 von zwei Anschlußstiften und das Hauptteil 17 von einem Gehäuse gebildet ist.

Die Montageeinrichtung weist eine Klemmvorrichtung 20 auf, bei der an einer Grundplatte 21 zwei Spannschie ber 22, 23 verschieblich gelagert sind. Die Grundplatte 21 ist mit Löchern 24 zur Aufnahme der Anschlußstifte 19 versehen. Die Spannschieber 22, 23 sind mit Prismen 25 ausgestattet. Beim Zusammenschieben der Spannschieber 22, 23 ist das mit seinen Anschlußstiften 19 in die Löcher 24 eingesteckte Bauelement 18 an den Anschlußstiften 19 ausgerichtet gehalten.

Der Klemmvorrichtung 20 ist eine Zuführungs-. schiene 26 zugeordnet, auf der das Bauelement 18 zu der Klemmvorrichtung 20 gebracht wird.

Die Klemmvorrichtung 20 ist in einem bestimmten Abstand zu einer Arbeitsstation 27 angeordnet. Auf dieser ist im Beispielsfalle eine gelochte Trägerplatte 28 festgelegt. Die Anordnung ist so getroffen, daß die für die Anschlußstifte 19 vorgesehenen Löcher 29 der Trägerplatte 28 einen vorbestimmten Abstand A von der Mitte der Löcher 24 haben.

Die beschriebene Montageeinrichtung arbeitet im wesentlichen folgendermaßen:

Zunächst wird ein Bauelement 18 der Klemmvorrichtung 20 zugeführt und mit seinen Anschlußstiften 19 in die Löcher 24 gesteckt. Die Spannschieber 22, 23 halten die Anschlußstifte 19 zentriert. An der Unterseite der Grundplatte 21 kann zusätzlich eine Schneidvorrichtung vorgesehen sein, die die Anschluß stifte 19 auf eine gewünschte Länge kürzt.

Anschließend wird der Transportkopf 1 mit geöffneter Spannzange 9 zum Bauelement 18 in eine vorbestimmte Position gefahren. Die Spannzange 9 übergreift das Gehäuse 17 des Bauelements 18. Sie wird dann geschlossen. Dabei verschiebt oder verdreht sich die Haltevorrichtung 7 gegenüber dem Transportkopf 1 entsprechend der jeweiligen Abweichung des Gehäuses 17 vom Nennwert.

Anschließend wird die vom Elektromagnet 3, 4 bzw. dem Bund 6 gebildete Feststellvorrichtung dadurch betätigt, daß der Magnet erregt wird. Anschließend werden die Spannschieber 22 und 23 geöffnet.

Schließlich wird der jetzt das Bauelement 18 haltende Transportkopf 1 angehoben und um die in der Steuereinrichtung des Roboters gespeicherte bestimmte Strecke A zu der Arbeitsstation 27 gefahren. Die Anschlußstifte 19 fluchten dort mit den Löchern 29, so daß durch Absenken des Transportkopfes 1 die Anschlußstifte 19 in die Löcher 29 der Trägerplatte 28 eingesetzt werden.

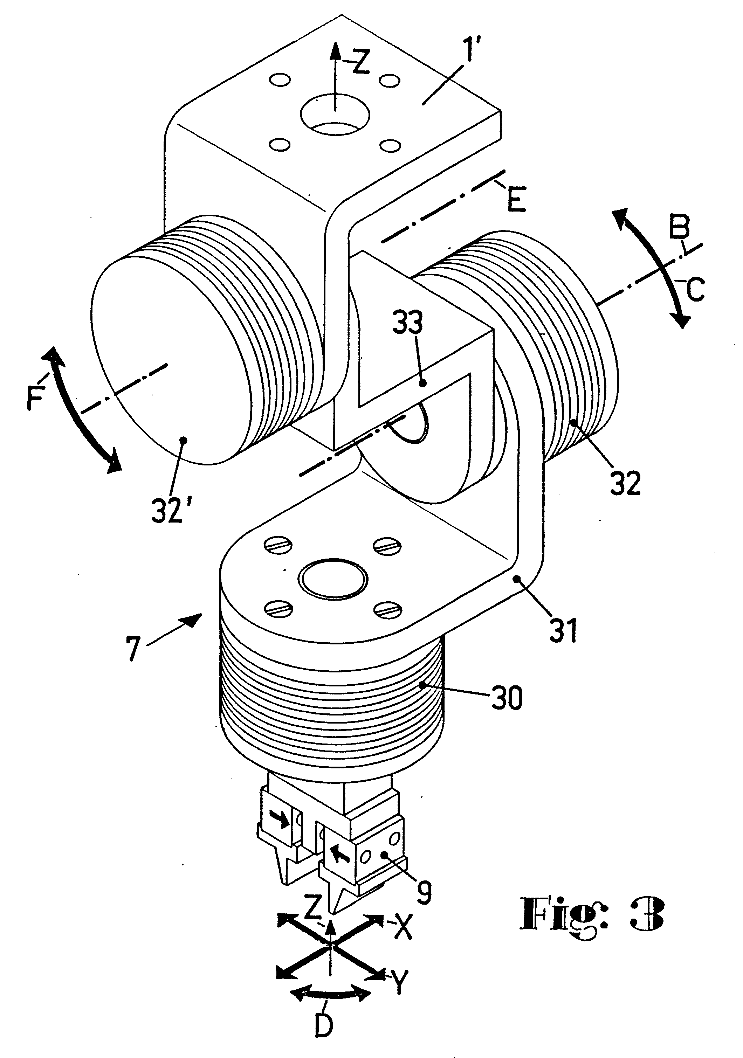

Beim Ausführungsbeispiel nach Figur 3 ist die Haltevorrichtung 7 am Transportkopf 1 auch pendelnd gelagert. Die Spannzange 9 ist dabei in einem Gehäuse 30 in der X-Y-Ebene verschiebbar und um die Z-Achse drehbar und feststellbar. Das Gehäuse 30 ist an einem Winkelstück 31 befestigt, welches um eine zur X-Richtung parallele Achse B in Richtung des Pfeiles C schwenkbar ist. In einem weiteren Gehäuse 32 ist eine Feststellvorrichtung, welche das Winkelstück 31 nach einer in Richtung des Pfeiles C erfolgten Verschwenkung gegenüber einem Doppelwinkelstück 33 blockiert. Das Doppelwinkelstück 33 ist um eine weitere, zur Achse B parallele Achse E in Richtung des Pfeiles F verschwenkbar. In einem weiteren Gehäuse 32' ist eine weitere Feststellvorrichtung vorgesehen, welche das Doppelwinkelstück 33 nach einer in Richtung des Pfeiles F erfolgten Verschwenkung blockiert. Das Gehäuse 32' ist an einem an Transportkopf 2 befestigten Halter 1' festgelegt.

Die Haltevorrichtung 7 nach Figur 3 wird verwendet, wenn damit zu rechnen ist, daß das Gehäuse 17 des Bauelements 18 dann, wenn dessen Anschlußstifte 19 in der Klemmvorrichtung 20 gehalten ist, in der Y-Z-Ebene schiefsteht. Ergreift in diesem Fall die Spannzange 9 das Schiefstehende Gehäuse 17, dann schwenkt sich die Haltevorrichtung 7 um die Achsen B und E entsprechend mit. In dieser Lage werden dann die in den Gehäusen 32 und 32' vorgesehenen Feststellvorrichtungen arretiert. Die Verschwenkbarkeit um die beiden beabstandeten Achsen B und E ist günstig, da dann, wenn nur eine Achse vorgesehen wäre, die Spannzange 9 beim Verschwenken um diese Achse entsprechend ihrem Achsabstand die Tendenz hätte, das Gehäuse 17 des Bauelements 18 gegenüber den festliegenden Anschlußstiften 19 zu bewegen. Die Verschwenkmöglichkeit um beide Achsen B und E verhindert dies.

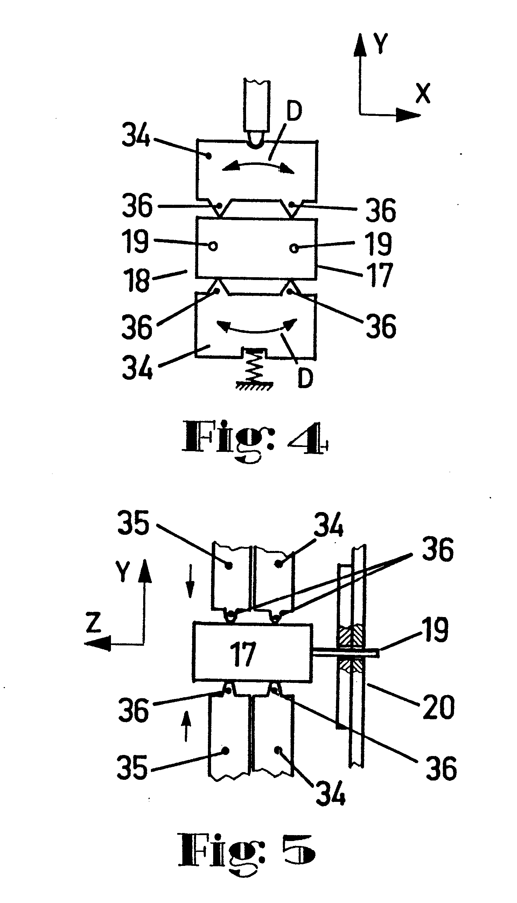

Beim Ausführungsbeispiel nach Figur 4 und 5 ist keine Spannzange zum Ergreifen des Bauelements 18 vorgesehen. Die Haltevorrichtung 7 weist zwei Klemmplattenpaare 34 und 35 auf. Jede Klemmplatte ist mit zwei Angriffsnocken 36 versehen. Zum Ergreifen des Bauelements 18 werden die Klemmplattenpaare 34 und 35 in geöffneter Stellung über das Gehäuse 17 gefahren. Anschließend werden die Klemmplatten der Klemmplattenpaare 34 und 35 gegen das Gehäuse 17 bewegt, so daß die Angriffsnocken 36 mit einer gewissen Andruckkraft beidseitig am Gehäuse 17 anliegen. Die Klemmplatten passen sich in ihrer Stellung dabei der jeweiligen Lage des Gehäuses 17 bezüglich der Anschlußstifte 19 an und zwar sowohl hinsichtlich einem Versatz des Gehäuses 17 in Y-Richtung, als auch einer Schrägstellung in der Y-Z-Ebene. Anschließend werden dann die Klemmplattenpaare 34 und 35 der Haltevorrichtung 7 festgestellt. Die Klemmvorrichtung 20 wird dann gelöst und das Bauelement 18, wie beschrieben, zur Arbeitsstation 27 befördert. Die Haltevorrichtung 7 nach den Figuren 4 und 5 kann die Haltevorrichtung 7 nach Figur 3 ersetzen. Beim Ausführungsbeispiel nach Figur 4 und 5 übernehmen die Klemmplattenpaare 34 und 35 zugleich die Funktion der Spannzange 9 und die Funktion der beweglichen Lagerung des Lagerstücks 8. Die Klemmplatten der Klemmplattenpaare 34 und 35 sind so gelagert, daß sie sich auch durch Drehung in Richtung der Pfeile D an das Gehäuse 17 anpassen.

Im Rahmen der Erfindung liegen zahlreiche weitere Ausführungsbeispiele. Beispielsweise könnten anstelle der Spannzange 9 auch andere Greifer vorgesehen sein. Es ist auch möglich, hydraulische oder pneumatische Feststellvorrichtungen zu verwenden.

Die Montageeinrichtung kann auch so gestaltet sein, daß der Transportkopf 1 selbst aus einem Magazin das Bauelement 18 der Klemmvorrichtung 20 zuführt.

Bezugszeichenliste 02/85

1 Transportkopf
2 Arm
3 Weicheisenkern
4 Spule
5 Kugelring

6 Bund

7 Haltevorrichtung

8 Lagerstück

9 Spannzange

10 Backen

11 Kugel

12 Druckfeder

13 Sechseckige Öffnung

14 Bodenplatte

15 Sechseckiger Querschnitt

16 Spalt

17 Hauptteil, Gehäuse

18 Bauelement

19 Einsteckteil, Anschlußstifte

20 Klemmvorrichtung

21 Grundplatte

22 Spannschieber

23 Spannschieber

24 Löcher

25 Prismen

26 Zuführungsschiene

27 Arbeitsstation

28 Trägerplatte

29 Löcher

30 Gehäuse

31 Winkelstück

32,32' Gehäuse

33 Doppelwinkelstück

34 Klemmplattenpaar

35 Klemmplattenpaar

36 Angriffsnocken

## Ansprüche

1. Montageeinrichtung zur lagerichtigen Zuführung eines Bauelements zu einem in einer Arbeitsstation gehaltenen Träger, wobei die Montageeinrichtung an einem Transportkopf eine Haltevorrichtung aufweist, die beim Transport das Bauelement an seinem Hauptteil hält und das Bauelement außer dem Hauptteil wenigstens ein in den Träger einzuführendes Einsteckteil aufweist, dadurch gekennzeichnet, daß in einem bestimmten Abstand (A) zur Arbeitsstation (27) eine Klemmvorrichtung (20) angeordnet ist, in der das Bauelement (18) an seinem Einsteckteil (19) ausgerichtet zu halten ist, daß die Haltevorrichtung (7) am Transportkopf (1) beweglich gelagert ist und daß eine Feststellvorrichtung - (3, 4, 6) zwischen dem Transportkopf (1) und der Haltevorrichtung (7) vorgesehen ist, die die Haltevorrichtung (7) gegenüber dem Transportkopf (1) arretiert, wenn die Haltevorrichtung (7) das Hauptteil (17) des mit seinem Einsteckteil (19) an der Klemmvorrichtung (20) eingespannten Bauelements (18) fest ergriffen hat.

2. Montageeinrichtung nach Anspruch 1, dadurch gekennzeichnet, daß die Haltevorrichtung (7) in der X-Y-Ebene verschieblich und um die Z-Achse drehbar am Transportkopf (1) gelagert ist.

3. Montageeinrichtung nach Anspruch 1 oder 2, dadurch gekennzeichnet, daß die Haltevorrichtung (7) am Tastkopf (1, 1') pendelnd und gegen die Pendelbewegung feststellbar gelagert ist.

4. Montageeinrichtung nach Anspruch 3, dadurch gekennzeichnet, daß die Haltevorrichtung (7) um zwei parallele Achsen (B, E) am Tastkopf (1, 1') pendelnd gelagert ist.

5. Montageeinrichtung nach Anspruch 1 oder 2, dadurch gekennzeichnet, daß die Haltevorrichtung (7) wenigstens zwei Klemmplattenpaare (34, 35) aufweist.

6. Montageerichtung nach einem der vorhergehenden Ansprüche, dadurch gekennzeichnet, daß Anschläge zur Begrenzung der freien Beweglichkeit der Haltevorrichtung (7) gegenüber dem Transportkopf (1) vorgesehen sind.

7. Montageeinrichtung nach Anspruch 6, dadurch gekennzeichnet, daß als Anschlag am Transportkopf (1) eine vieleckige Öffnung (13) vorgesehen ist, in die die Haltevorrichtung (7) mit einem entsprechend vieleckigen Querschnitt (15) ragt.

8. Montageeinrichtung nach einem der vorhergehenden Ansprüche, dadurch gekennzeichnet, daß die Haltevorrichtung (7) über einen Kugelring - (5) am Transportkopf (1) schwimmend gelagert ist.

9. Montageeinrichtung nach einem der vorhergehenden Ansprüche, dadurch gekennzeichnet, daß die Haltevorrichtung (7) mittels einer Feder - (12) in Mittenstellung gedrückt ist.

10. Montageeinrichtung nach Anspruch 9, dadurch gekennzeichnet, daß die Feder (12) in Z-Richtung auf eine Kugel - (11) drückt, die in einer Vertiefung der Haltevorrichtung (7) gelagert ist.

11. Montageeinrichtung nach einem der vorhergehenden Ansprüche 1 bis 4 und 7 bis 10, dadurch gekennzeichnet, daß die Haltevorrichtung (7) eine Spannzange (9) aufweist.

12. Montageeinrichtung nach einem der vorhergehenden Ansprüche, dadurch gekennzeichnet, daß die Feststellvorrichtung von einem Elektromagnet (3, 4) gebildet ist, der im Transportkopf (1) gelagert ist.

13. Montageeinrichtung nach einem der vorhergehenden Ansprüche,
dadurch gekennzeichnet,

daß die Klemmvorrichtung (20) eine Lochung (24) für das Einsteckteil (19) und Spannschieber (22, 23) zum Ausrichten des Einsteckteils (19) aufweist.

**Fig: 1**

**Fig: 2**

Fig. 3

Y

X

34

D

36                    36

19    ○        ○    19

18                    17

36                    36

34

D

# Fig. 4

35                34

36

Y

Z

17

36

19

20

35        36

34

# Fig. 5